Europäisches Patentamt

European Patent Office

Office européen des brevets

(11) Veröffentlichungsnummer: **0 472 051 A2**

# EUROPÄISCHE PATENTANMELDUNG

(21) Anmeldenummer: **91113246.2**

(22) Anmeldetag: **07.08.91**

(51) Int. Cl.⁵: **G03H 1/00**, G03F 7/20, H05K 3/00

(30) Priorität: **18.08.90 DE 4026234**

(43) Veröffentlichungstag der Anmeldung:
**26.02.92 Patentblatt 92/09**

(84) Benannte Vertragsstaaten:
**CH ES FR GB IT LI NL SE**

(71) Anmelder: **Hans Kolbe & Co.**
**Bodenburger Strasse 32**
**W-3202 Bad Salzdetfurth(DE)**

(72) Erfinder: **Hinken, Johann, Prof. Dr.-Ing.**
**Karl-Rieschel-Strasse 31**

**W-3201 Holle 1(DE)**
Erfinder: **Klinger, Martin, Dipl.-Ing.**
**Elsa-Brandström-Strasse 14**
**W-3202 Bad Salzdetfurth(DE)**
Erfinder: **Müller, Dieter, Dipl.-Ing.**
**Rustwiese 11**
**W-3370 Seesen(DE)**

(74) Vertreter: **Sobisch, Peter, Dipl.-Ing. et al**
**Patentanwälte Dipl.-Inge. Röse, Kosel &**
**Sobisch Odastrasse 4a Postfach 129**
**W-3353 Bad Gandersheim 1(DE)**

(54) **Verfahren zur dreidimensionalen fototechnischen Übertragung von Oberflächeninformationen eines Körpers.**

(57) Die dreidimensionale fototechnische Strukturierung der Oberflächen von Leiterplatten gestaltet sich nach den herkömmlichen Arbeitsverfahren zeit- und damit kostenintensiv. Zur Beschleunigung dieses Arbeitsverfahrens wird erfindungsgemäß vorgeschlagen, von einem, die zu übertragende Oberflächeninformation bzw. das Oberflächenmuster tragenden Originalkörper eine holographische Aufnahme bzw. ein Hologramm zu erstellen, welches die Information in einem Interferenzmuster fotografisch fixiert. Zur Wiedergabe der Information auf einem Bezugskörper gleicher Größe und Gestalt und damit zur beliebigen Vervielfältigung wird das Hologramm dazu benutzt, die Information auf den entsprechenden Oberflächen des Bezugskörpers abzubilden. Der Bezugskörper ist zu diesem Zweck mit einer geeigneten fotoempfindlichen Beschichtung überzogen, von deren spektraler Empfindlichkeit die Wahl der Wellenlänge für die Aufnahme und die Wiedergabe des Hologramms abhängt. Die Oberflächeninformation kann in einem einzigen Verfahrensgang sehr schnell und mit hohem sowie gleichmäßigem Auflösungsvermögen übertragen werden.

Fig. 2

Die Erfindung bezieht sich auf ein Verfahren entsprechend dem Oberbegriff des Anspruchs 1.

Elektrische Leiterplatten bestehen bekanntlich aus einem nicht leitfähigen Grundkörper, der ein, an eine jeweilige Problemstellung angepaßtes metallisch leitfähiges Leiterbild trägt. Zur Herstellung wird der aus einem temperaturbeständigen polymeren Werkstoff bestehende Grundkörper beispielsweise durch Spritzgießen geformt, wobei dessen Oberfläche anschließend vollflächig oder in Teilbereichen metallisiert wird, d.h. mit einer metallischen Schicht überzogen wird. In einem weiteren Verfahrensschritt wird diese Schicht zwecks Erstellung des Leiterbildes nach unterschiedlichen Verfahren teilweise abgetragen. Alternativ zu einem Abtragen kann mittels eines fotochemisch aktivierbaren Katalysators auch eine selektive, das Leiterbild unmittelbar herstellende Metallisierung vorgenommen werden. Ansonsten werden auf die metallische Schicht lichtempfindliche Schichten oder Abdecklacke z.B. durch Tauchverfahren, elektrostatisches Spritzen oder Elektrophorese aufgebracht, welche auf fototechnischem Wege, beispielsweise mittels eines Lasers je nach der Beschaffenheit der Schicht selektiv belichtet oder thermisch zersetzt werden, um anschließend durch Ätzen freigelegter metallischer Schichten das Leiterbild zu erstellen.

Diese bekannten Arbeitstechniken gestalten sich dann verhältnismäßig zeit- und kostenaufwendig, wenn es um dreidimensionale Leitbilder geht, bei denen somit mehrere, voneinander unterscheidbare Ebenen des genannten Grundkörpers Leiterbilder tragen, so daß eine Oberflächenbehandlung mehrerer Flächen des Grundkörpers vorgenommen werden muß. Bei Verwendung beispielsweise eines an einem Roboterarm geführten Lasers können zwar sämtliche Oberflächen des Grundkörpers mit einer Geschwindigkeit, die unter anderem von der durch die Beschaffenheit des Leiterbildes vorgegebenen und damit erforderlichen Auflösung abhängig ist, abgetastet werden - es gestaltet sich jedoch diese Vorgehensweise entsprechend der Abrasterung der Flächen sehr zeitaufwendig.

Die Verwendung von ebenfalls bekannten dreidimensionalen Abdeckmasken bei der Herstellung dieser Leiterplatten gestaltet sich arbeitstechnisch aufwendig und ist mit weiteren Nachteilen bezüglich des erreichbaren Auflösungsvermögens behaftet.

Es ist die Aufgabe der Erfindung, ein Verfahren der eingangs bezeichneten Gattung zu konzipieren, welches mit hoher Geschwindigkeit und insbesondere einfach durchführbar ist und gleichzeitig ein hohes und gleichmäßiges Auflösungsvermögen - über die Oberfläche des Bezugskörpers gesehen - gewährleistet. Gelöst ist diese Aufgabe bei einem gattungsgemäßen Verfahren durch die Merkmale des Kennzeichnungsteils des Anspruchs 1.

Erfindungswesentlich ist somit die Verwendung holographischer Aufnahme- und Wiedergabetechniken bei der Übertragung von Oberflächeninformationen, Flächenmustern oder dergleichen - ausgehend von einem Originalkörper, dessen Oberflächen die abzubildenden bzw. zu übertragenden Informationen tragen. Es wird im Regelfall davon ausgegangen, daß der Bezugskörper, der oberflächlich mit einer fotoempfindlichen Schicht überzogen ist, die gleiche Größe und insbesondere Gestalt wie der Originalkörper aufweist, so daß nach Erstellen der holographischen Aufnahme ausgehend von dieser in einem einzigen Belichtungsvorgang die Oberflächeninformation des Originalkörpers auf den Bezugskörper übertragbar ist. Die weitere Behandlung des in diesem Sinne belichteten Bezugskörpers kann entsprechend der Art der fotoempfindlichen Schicht erfolgen. Vorausgesetzt für die Erstellung der holographischen Aufnahme ist lediglich ein, in der genannten Ebene der holographischen Aufnahme befindliches, eine hinreichende Empfindlichkeit aufweisendes Filmmaterial, welches zur Fixierung des in dieser Ebene entstehenden Interferenzmusters geeignet ist.

Das Verfahren der Holographie als solches ist grundsätzlich bekannt. Es basiert auf der beispielsweise fotografischen Fixierung des Interferenzbildes zweier Wellenfelder, nämlich eines ersten, durch Streuung an dem abzubildenden Körper entstehenden und eines zweiten, vorzugsweise ebenen, von derselben, ein hinreichend kohärentes Licht emittierenden Lichtquelle herrührenden. Durch Bestrahlung des Interferenzbildes mit einem ebenen Wellenfeld der gleichen, der Aufnahme entsprechenden Wellenlänge ergibt sich am Ort der Aufnahme des genannten Körpers aufgrund von Reflexions- und Beugungserscheinungen der Welle an dem Interferenzbild ein Abbild des Körpers.

Es ist dieses Vefahren bisher jedoch nur zur Erzeugung räumlicher Bilder von Körpern, nicht jedoch zur Informationsübertragung von einem körperhaften Informationsträger auf einen anderen benutzt worden.

Von dem Originalkörper kann in bestimmten Fällen die Erstellung einer einzigen holographischen Aufnahme ausreichend sein. Es können jedoch gemäß den Merkmalen des Anspruchs 2 auch mehrere derartige Aufnahmen erstellt werden, insbesondere um Abschattungseffekte zu vermeiden und um sämtliche Seiten des Originalkörpers in einem einzigen Aufnahmevorgang erfassen zu können. Zur Wiedergabe können sämtliche holographische Aufnahmen einander überlagert werden, so daß - wiederum in einem einzigen Arbeitsvorgang sämtliche Oberflächeninformationen auf den Bezugskörper fototechnisch übertragbar sind.

Im Regelfall werden der Originalkörper und der Bezugskörper entsprechend den Merkmalen des Anspruchs 3 eine gleiche Größe und eine gleiche Gestalt aufweisen. Dies bedeutet insbesondere, das zur Erstellung der holographischen Aufnahme und zur Abbildung derselben auf den Bezugskörper eine Strahlung von gleicher Wellenlänge benutzt wird.

Gemäß den Merkmalen des Anspruchs 4 sind jedoch auch Vergrößerungen bzw. Verkleinerungen möglich, wobei der Originalkörper und der Bezugskörper zwar eine gleiche Gestalt, jedoch eine unterschiedliche Größe aufweisen. Das Flächenmuster der Oberflächen des Originalkörpers kann demzufolge auf dem Bezugskörper entsprechend dessen absoluter Größe entsprechend vergrößert oder verkleinert wiedergegeben werden. Dies kann bei der Wiedergabe der holographischen Aufnahme praktisch dadurch realisiert werden, daß eine andere Wellenlänge als bei der Aufnahme benutzt und/oder, daß ein entsprechendes geeignetes Linsensystem zur Änderung der Größenverhältnisse benutzt wird. Im ersteren Fall muß naturgemäß das auf dem Bezugskörper befindliche fotoempfindliche Material insbesondere hinsichtlich seiner spektralen Eigenschaften in Abhängigkeit von der geänderten Wellenlänge gewählt werden.

Entsprechend den Merkmalen der Ansprüche 5 und 6 kann zur Aufnahme und zur Wiedergabe die gleiche Strahlungsquelle, nämlich eine Laserquelle benutzt werden. Zur Aufnahme ist eine Laserquelle bzw. eine sonstige, ein hinreichend kohärentes Licht emittierende Strahlungsquelle in jedem Fall erforderlich, während zur Wiedergabe auch eine sonstige, monochromatische Lichtquelle ausreichend ist.

Wichtigster Anwendungsfall ist entsprechend den Merkmalen des Anspruchs 7 die Herstellung dreidimensionaler Leiterplatten, die in wenigstens zwei, sich an beliebiger Stelle des Grundkörpers befindlichen Ebenen elektrische Leiterbilder ragen. Das erfindungsgemäße Verfahren betrifft lediglich die fototechnische Strukturierung der Leiterplattenoberfläche, wohingegen die weitere Behandlung gemäß den bekannten Verfahren erfolgen kann. Die Anwendung des Verfahrens führt in diesem Bereich zu einer bedeutenden Senkung des Zeitbedarfs für die Herstellung einer dreisimensionalen Leiterplatte.

Das erfindungsgemäße Verfahren ist jedoch nicht nur bei der Herstellung von Leiterplatten anwendbar, sondern kann in allen denjenigen Fällen mit Vorteil eingesetzt werden, bei denen Oberflächeninformationen irgendwelcher Art auf einen vorzugsweise gestaltlich und auch in sonstiger Weise identischen Bezugskörper auf fototechnischem Wege mit hohem Auflösungsvermögen zu übertragen sind. Anwendungsmöglichkeiten bestehen allgemein in der graphischen Industrie, z.B. bei fototechnischer Übertragung von Texten und Bildern auf räumliche Objekte, z.B. Werbeträger, Verpakkungen etc.

Die Erfindung wird im folgenden unter Bezugnahme auf die zeichnerisch wiedergegebenen Prinzipdarstellungen näher erläutert werden. Es zeigen:

Fig. 1 eine Anordnung zur holographischen Aufnahme eines Körpers;

Fig. 2 ein erstes Beispiel einer Anordnung zur holographischen Wiedergabe des Körpers,

Fig. 3 ein zweites Beispiel einer Anordnung zur holographischen Wiedergabe des Körpers;

Fig. 4 eine Darstellung eines mit Testzwecken dienender grafischer Oberflächeninformation versehenen Originalkörpers;

Fig. 5 eine Darstellung des holographisch rekonstruierten Bildes der Oberflächeninformation auf einem geometrisch identischen Referenzkörper.

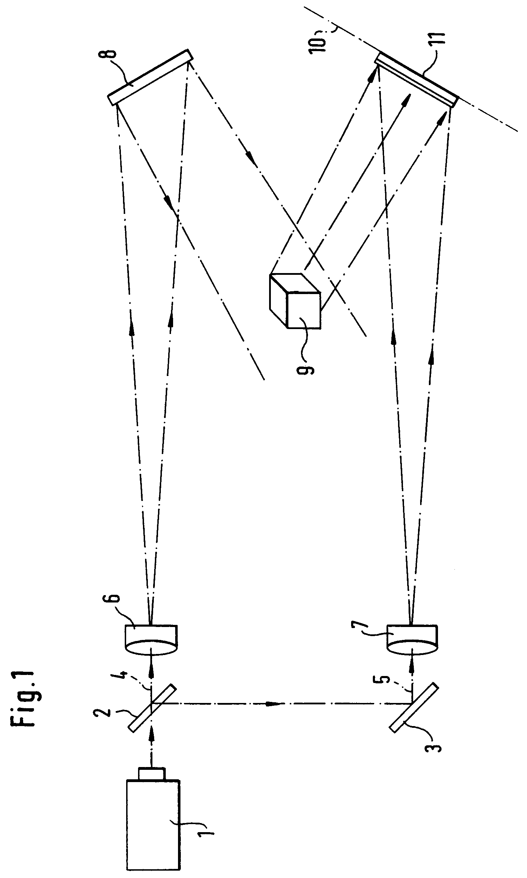

Mit 1 ist in Fig. 1 ein Laser, beispielsweise ein Argon-Laser bezeichnet, in dessen Strahlengang sich ein Strahlungsteiler 2 befindet, wobei unter Mitwirkung eines Spiegels 3 zwei zueinander parallele Strahlengänge 4 und 5 erzeugt werden.

Im Verlauf beider Strahlengänge 4, 5 befinden sich gleichartige Linsensysteme 6, 7, die der Erzeugung leicht divergenter Strahlenbündel dienen.

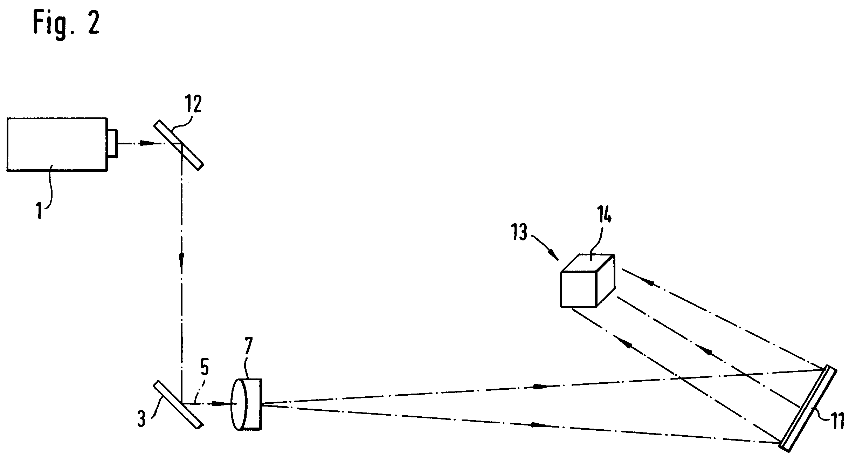

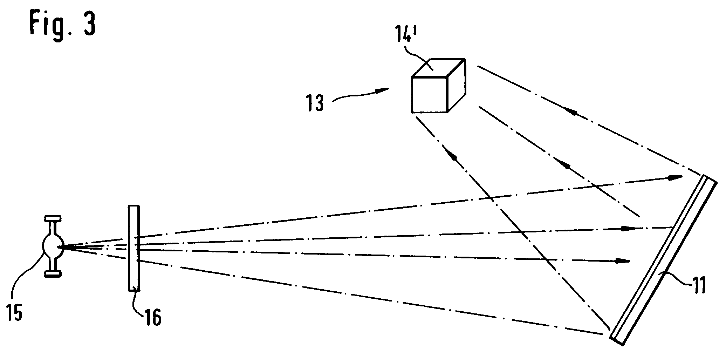

Mit 8 ist ein Spiegel bezeichnet, durch den die, aus dem Linsensystem 6 austretende Strahlung reflektiert wird und in Richtung auf einen Körper 9 umgelenkt wird. Der Körper 9 ist zeichnerisch lediglich als Würfel wiedergegeben. Praktisch kann es sich hierbei um einen Körper nach Art einer Leiterplatte handeln, dessen Oberflächen bestimmte Leiterbilder tragen. Die an dem Körper 9 gestreute Strahlung wird mit derjenigen des Linsensystems 7 überlagert, wobei das sich in einer Ebene 10 ergebende Interferenzbild fotografisch festgehalten wird. Zu diesem Zweck befindet sich in der Ebene 10 eine mit einer fotoempfindlichen Schicht überzogene Platte 11. Die Platte 11 ist in zeichnerisch nicht dargestellter Weise ortsfest gehalten und steht insbesondere zu den auf sie treffenden Strahlungen unter einem definierten Winkel. Das auf dieser Platte 11 sich ergebende Interferenzbild stellt das Hologramm dar, aus welchem ein räumliches Bild des Körpers 9 rekonstruierbar ist. Hierzu wird auf die Anordnungen gemäß den Fig. 2 und 3 Bezug genommen.

Zur Wiedergabe dient gemäß Fig. 2 eine der Fig. 1 ähnliche Anordnung, wobei lediglich der Strahlenteiler 2 durch einen Spiegel 12 ersetzt ist und wobei der Spiegel 8 entfällt. Der aus dem Laser 1 austretende Strahl gelangt somit über die Spiegel 12, 3 und das Linsensystem 7 in der Form eines schwach divergenten Strahlenganges auf das Hologramm 11, wobei an dessen Interferenzbild durch Reflexion und Beugung ein Wellenfeld gebildet wird, durch welches an der Stelle 13 ein Abbild 14 des Referenzkörpers 9 entsteht.

Bei der Anordnung gemäß Fig. 3 wird zur Wiedergabe wiederum von dem Hologramm 11 augegangen, wobei als Strahlungsquelle eine Quecksilberhochdrucklampe 15 benutzt wird, aus deren Spektrum mittels eines geeigneten Filters 16 die der Aufnahme entsprechende Wellenlänge ausgekoppelt wird, so daß auf das Hologramm eine monochromatische Strahlung auftrifft, die in gleicher Weise zur Entstehung eines Abbilds 14' an der Stelle 13 führt.

Es ist dieses holographische Abbildungsverfahren eines Objektes, welches bei der Aufnahme auf der fotografischen Fixierung des Interferenzbildes einer im wesentlichen ebenen Welle und einer von dem Objekt gestreuten Welle und bei der Wiedergabe bzw. Rekonstruktion eines Abbildes des Gegenstands auf der Beugung einer im wesentlichen ebenen Welle an den Strukturen des Interferenzmusters basiert - wie oben bereits ausgeführt - insoweit bekannt. Voraussetzung sowohl für Aufnahme und Wiedergabe ist eine monochromatische Lichtquelle hinreichender Kohärenz, von der sowohl die an dem abzubildenden Gegenstand gestreute, als auch die Referenzstrahlung abgeleitet werden, aus deren Interferenz das Hologramm gebildet wird. Voraussetzung ist ferner eine genaue und insbesondere reproduzierbare Positioniermöglichkeit für das abzubildende Objekt sowie die, das Hologramm während der Aufnahme und der Wiedergabe halternde Einrichtung, hier die Platte 11. Es kommt als Strahlungsquelle somit zur Aufnahme praktisch nur eine Laserquelle in Betracht. Zur Wiedergabe kann wiederum die gleiche Laserquelle benutzt werden, es kommt jedoch auch eine andere monochromatische Lichtquelle gleicher Wellenlänge in Betracht.

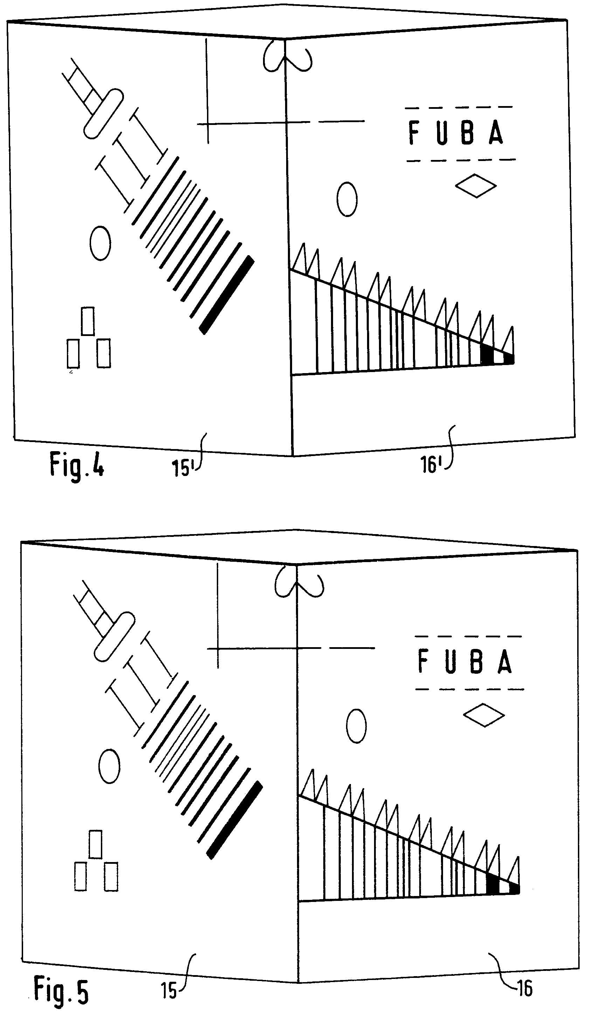

Erfindungsgemäß wird dieses holographische Abbildungsverfahren nunmehr dazu verwendet, um beliebige, räumlich auf der Oberfläche eines Körpers in der Form eines Flächenmusters fixierte Informationen auf einen Körper gleicher Gestalt zu übertragen. Lediglich zur Verdeutlichung eines Ausführungsbeispiels dient der in den Fig. 4 und 5 schematisch abgebildete Versuchskörper.

Fig. 5 zeigt das Original eines aus Plexiglas bestehenden Würfels, dessen beide Vorderseiten 15, 16 das dargestellte Flächenmuster zeigten. Es handelte sich hierbei um ein Schwarz-Weiß-Muster auf einer mattierten Oberfläche. Dieser Würfel wurde in einer geeigneten Einrichtung mit einer reproduzierbaren Einstellposition fixiert und zur Erstellung eines Hologramms in Auflicht bei einer Wellenlänge von 488 nm aufgenommen.

Ein Würfel gleicher Gestalt, und Abmessungen, jedoch mit weißer Oberfläche und ohne die Testbilder des Originalwürfels wurde anschließend in exakt der gleichen Position angeordnet, in der sich der Originalwürfel befunden hat. Über das ebenfalls in gleicher Position wie bei der Aufnahme befindliche Hologramm wurden anschließend die Seiten 15, 16 des Originalwürfels auf die entsprechenden Seiten 15', 16' des weißen Würfels projiziert, wobei sich das in Fig. 4 gezeigte Bild ergeben hat, welches insoweit eine genaue Rekonstruktion der Testinformation des Originalwürfels darstellt.

Es können auf diesem Wege grundsätzlich auch Oberflächeninformationen sämtlicher Seiten des Würfels einheitlich, somit in einem einheitlichen Projektionsverfahren auf die entsprechende Oberfläche eines Würfels abgebildet werden. Hierzu sind lediglich mehrere Hologramme erforderlich, um die sich ansonsten ergebenden Abschattungseffekte zu vermeiden, wobei diese mehreren Hologramme problemlos zur einheitlichen Projektion der genannten Information überlagert werden können. Beschränkungen hinsichtlich der Größe des zur Abbildung benutzten Grundkörpers ergeben sich lediglich aus der Forderung nach einer sehr genauen, insbesondere reproduzierbaren Positionierbarkeit desselben, welche unterhalb einer bestimmten Größe problematisch wird. Mit zunehmender Größe des genannten Grundkörpers erhöht sich die Fläche des Hologramms und damit die erforderliche Laserleistung bzw. Belichtungsdauer, woraus sich im Einzalfall apparative, jedoch keine prinzipiellen Beschränkungen ergeben. Die Geometrie des zu Abbildungszwecken benutzten Grundkörpers ist grundsätzlich beliebig und keineswegs auf einfache geometrische Formen wie Kugel, Quader, Würfel. Kegelschnitt und dergleichen beschränkt. Lediglich bei bestimmten, zu einer Fokussierung der auftreffenden Strahlung führenden Krümmungsformen können Probleme bzw. Unschärfen auftreten.

Indem der als Projektionsfläche dienende Körper mit einer entsprechenden fotoempfindlichen Beschichtung überzogen ist, können auf diesem Wege - ausgehend von einem oder mehreren Hologrammen, jedoch in einem einzigen einheitlichen Projektionsverfahren - dem Original geometrisch entsprechende Referenzkörper allseitig mit Informationen beliebiger Art, wie z.B. Bildern, Text usw. überzogen werden. Das erfindungsgemäße Verfahren betrifft jedoch lediglich die räumliche Belichtung eines Referenzkörpers. Dessen weitere Behandlung gestaltet sich in Abhängigkeit von der Beschaffenheit der fotoempfindlicher Beschichtung.

Das wesentliche Anwendungsgebiet des Erfindungsgegenstands liegt jedoch in der Oberflächengestaltung dreidimensionaler Leiterplatten, insbesondere deren fototechnischer Strukturierung, wobei somit in einem einzigen Arbeitsgang sämtliche Oberflächen der Leiterplatte behandelt werden können.

Ausgegangen wird hierbei von einem im Oberflächenbereich metallisierten, d.h. eine metallische Schicht tragenden Grundkörper, der aus Polymeren wie z.B. Polyätherimid, Polysulfone, Liquid Crystal Polymeren usw. besteht, wobei auf fototechnischem Wege die metallische Schicht entsprechend der jeweils zu realisierenden Schaltung in ein Netzwerk einzelner Leiterbahnen umzugestalten ist. Dieser Gestaltung, welche beispielsweise durch Ätzen durchführbar ist, geht eine fototechnische Übertragung des gewünschten Leiterbildes auf eine die metallische Schicht abdeckende lichtempfindliche Schicht voraus. Geht man demzufolge von metallisierten, im Oberflächenbereich mit fotoempfindlichen Schichten überzogenen Grundkörpern der genannten Art aus, können erfindungsgemäß ausgehend von einem bzw. mehreren Hologrammen - jedoch in einem einzigen Projektionsverfahren - jeweils dreidimensionale fototechnische Oberflächenstrukturierungen vorgenommen werden, deren weitere Verarbeitung in an sich bekannter Weise erfolgen kann. Durch die Zusammenfassung der Strukturierung sämtlicher Oberflächen des Grundkörpers in einem einzigen einheitlichen Projektionsverfahren entfallen somit sämtliche, durch das sequentielle Abrastern der einzelnen Oberflächen bedingten Zeitnachteile ebenso wie die mit der Erstellung dreidimensionaler Abdeckmasken verbundenen Probleme.

**Patentansprüche**

1. Verfahren zur fototechnischen Übertragung der Oberflächeninformationen eines Körpers auf einen Bezugskörper, dadurch gekennzeichnet, daß von dem Körper wenigstens eine holographische Aufnahme angefertigt wird, daß die Aufnahme auf den, mit einer fotoempfindlichen Schicht überzogenen Bezugskörper holographisch abgebildet wird und daß der belichtete Bezugskörper zwecks Gewinnung der Oberflächeninformationen in an sich bekannter Weise behandelt wird.

2. Verfahren nach Anspruch 1, dadurch gekennzeichnet, daß von dem Körper gleichzeitig zwei oder mehr holographische Aufnahmen - jeweils aus unterschiedlichen definierten Richtungen - angefertigt werden und daß sämtliche holographischen Aufnahmen - den jeweiligen Richtungen zugeordnet - gleichzeitig oder sequenziell auf den mit einer fotoempfindlichen Schicht überzogenen Bezugskörper abgebildet werden.

3. Verfahren nach Anspruch 1 oder 2, dadurch gekennzeichnet, daß der Körper und der Bezugskörper eine gleiche Größe und Gestalt aufweisen.

4. Verfahren nach Anspruch 1 oder 2, dadurch gekennzeichnet, daß der Körper und der Bezugskörper eine gleiche Gestalt, jedoch unterschiedliche Größen aufweisen.

5. Verfahren nach einem der vorangegangenen Ansprüche 1 bis 4, dadurch gekennzeichnet, daß sowohl zur Aufnahme als auch zur Abbildung die Strahlung einer Laserquelle oder einer sonstigen, ein hinreichend kohärentes Licht emittierenden Strahlungsquelle benutzt wird.

6. Verfahren nach einem der vorangegangenen Ansprüche 1 bis 4, dadurch gekennzeichnet, daß zur Aufnahme die Strahlung einer Laserquelle oder einer sonstigen, ein hinreichend kohärentes Licht emittierenden Strahlungsquelle und zur Abbildung eine entsprechende sonstige monochromatische Lichtquelle, beispielsweise eine Quecksilber-Hochdrucklampe gegebenenfalls mit einem Monochromator benutzt wird.

7. Anwendung des Verfahrens nach einem der vorangegangenen Ansprüche 1 bis 6 zur fototechnischen dreidimensionalen Strukturierung der Oberflächen von Leiterplatten.

8. Anordnung zur Durchführung des Verfahrens nach einem der vorangegangenen Ansprüche 1 bis 7, gekennzeichnet durch eine, ein hinreichend kohärentes Licht emittierende Strahlungsquelle, insbesondere einen Laser (1), eine Einrichtung zur Justierung des Ortes des die abzubildende Oberflächeninformation tragenden Körpers (9) bzw. des eine fotoempfindliche Beschichtung tragenden Bezugskörpers, eine Einrichtung zur Justierung der holographischen Aufnahme in einer Ebene (10) und ein optisches System, mittels welchem zur Herstellung der wenigstens einen holographischen Aufnahme die von dem Körper gestreute Strahlung in der Ebene (10) mit einer, von der gleichen Strahlungsquelle herrührenden Referenzstrahlung interferiert und mittels welchem zur holographischen Abbildung der Oberflächeninformation des Körpers auf die Oberfläche des Bezugskörpers eine, zur Richtung der Referenzstrahlung der Aufnahme richtungsgleiche Referenzstrahlung auf die in der Ebene (10) befindliche holographische Aufnahme richtbar ist.

Fig.1

EP 0 472 051 A2

Fig. 2

Fig. 3

EP 0 472 051 A2

Fig.4    15'    16'

Fig.5    15    16